**Europäisches Patentamt**

**European Patent Office**

**Office européen des brevets**

(11) Veröffentlichungsnummer: **0 520 209 A1**

# EUROPÄISCHE PATENTANMELDUNG

(21) Anmeldenummer: **92109256.5**

(22) Anmeldetag: **02.06.92**

(51) Int. Cl.5: **H01L 27/092**, H01L 21/82

(30) Priorität: **26.06.91 DE 4121051**

(43) Veröffentlichungstag der Anmeldung:
**30.12.92 Patentblatt 92/53**

(84) Benannte Vertragsstaaten:
**DE FR GB IT NL**

(71) Anmelder: **EUROSIL electronic GmbH**
**Erfurter Strasse 16**
**W-8057 Eching(DE)**

(72) Erfinder: **Fischer, Gerhard, Dr.**
**Siedlerstrasse 17a**
**W-8044 Unterschleissheim(DE)**
Erfinder: **Plagge, Walter**
**Michl-Lang-Weg 6**
**W-8000 München 83(DE)**

(74) Vertreter: **Maute, Hans-Jürgen, Dipl.-Ing.**
**TELEFUNKEN electronic GmbH**
**Theresienstrasse 2**
**W-7100 Heilbronn(DE)**

(54) CMOS Halbleiteranordnung und Verfahren zu seiner Herstellung.

(57) Es wird eine Halbleiteranordnung in einer CMOS-Technologie beschrieben, bei der die Gate-Elektroden bei p-Kanal-Transistoren aus $p^+$-dotiertem Polysilizium und bei n-Kanal-Transistoren aus $n^+$-dotiertem Polysilizium bestehen. Sind die Gate-Elektroden zweier komplementärer Transistoren auf Gate-Ebene miteinander verbunden, so entsteht an der Verbindungsstelle eine Polysiliziumdiode. Erfindungsgemäß wird diese Polysiliziumdiode mit einer Polysilizidschicht kurzgeschlossen. Es wird ein Verfahren beschrieben, wie diese Polysiliziumdiode ohne zusätzliche Maskenschritte anhand einer Metallsilizidschicht kurzgeschlossen wird. In einer weiteren Ausführungsform der Erfindung ist das Silizid auf den Bereich der Polysiliziumdiode beschränkt. Weiterhin wird ein Verfahren beschrieben, mit welchem die Polysiliziumdioden in einem selbstjustierenden Polyzidprozeß kurzgeschlossen werden.

FIG.9

Die Erfindung betrifft eine Halbleiteranordnung nach dem Oberbegriff des Anspruchs 1. Weiterhin betrifft die Erfindung ein Verfahren zur Herstellung einer derartigen Halbleiteranordnung.

Um in einer CMOS-Technologie Transistoren mit Gate-Längen von weniger als 2 $\mu$m und niedrigen Einsatzspannungen herzustellen, ist es erforderlich die Gate-Elektroden bei p-Kanal-Transistoren aus $p^+$-dotiertem Polysilizium und bei n-Kanal-Transistoren aus $n^+$-dotiertem Polysilizium herzustellen. Wird ein Logikelement aus zwei derartigen p- und n-Kanal-Transistoren aufgebaut, deren Gate-Elektroden auf der Polysiliziumebene miteinander verbunden sind, wie z. B. bei einem CMOS-Inverter, so entsteht an der Verbindungsstelle des $p^+$-dotierten Polysilizium-Gates des p-Kanal-Transistors mit dem $n^+$-dotierten Polysilizium-Gate des n-Kanal-Transistors eine Polysiliziumdiode. Bis auf wenige Ausnahmen ist diese Polysiliziumdiode unerwünscht und muß daher kurzgeschlossen werden, um ein Funktionieren des Logikelements zu gewährleisten. Üblicherweise geschieht dies mit Hilfe von auf den Polysiliziumdioden angeordneten Metallisierungsbahnen und mit auf beiden Seiten des $p^+$-$n^+$-Übergangs angeordneten Kontaktlöchern. Nachteilig bei einem derartigen Kurzschließen der Polysiliziumdioden ist, daß aufgrund der Kontaktanordnung ein erhöhter Platzbedarf im Bereich der kurzgeschlossenen Polysiliziumdiode auftritt. Bei der Herstellung eines derartigen Halbleiterelements sind außerdem zusätzliche Masken- und Fotoschritte erforderlich.

Aus EP 325 328 A1 ist ein Verfahren bekannt, um bei MOS-Transistoren mit Polysilizium-Gate-Elektroden das Polysilizium mit einer Metallsilizidschicht zu versehen. Damit wird eine Verringerung des Schichtwiderstands der Gate-Elektrode und somit eine höhere Schaltgeschwindigkeit des Transistors erzielt.

Aufgabe der Erfindung ist es daher eine Halbleiteranordnung nach dem Oberbegriff des Anspruchs 1 anzugeben, bei der die Polysiliziumdioden ohne erhöhten Platzbedarf kurzgeschlossen sind. Diese Aufgabe wird gelöst durch eine Halbleiteranordnung mit den kennzeichnenden Merkmalen des Anspruchs 1.

Eine weitere Aufgabe der Erfindung ist es, ein Verfahren anzugeben, mit dem eine derartige Halbleiteranordnung, ohne zusätzliche Masken- und Fotoschritte hergestellt werden kann. Diese Aufgabe wird gelöst durch ein Verfahren mit den Merkmalen des Anspruchs 4 bzw. Anspruchs 5.

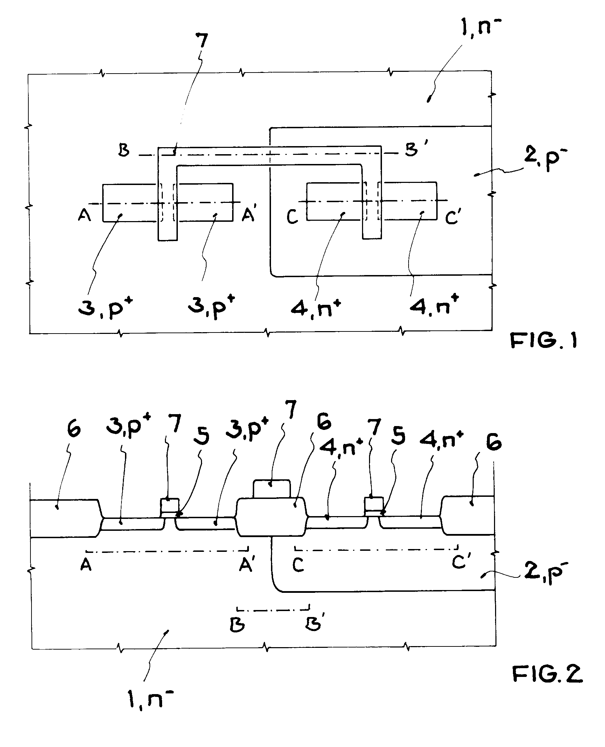

Figur 1 zeigt eine CMOS-Halbleiteranordnung bestehend aus einem n-Kanal- und einem p-Kanal-Transistor mit auf Polysiliziumebene verbundenen Gate-Elektroden.

Figur 2 zeigt einen Schnitt durch die Anordnung nach Figur 1 wobei die Schnittlinie BB' zur besseren Übersicht verkürzt dargestellt ist. Im Bereich der Schnittlinie AA' befindet sich im Substrat 1 der p-Kanal-Transistor und im Bereich der Schnittlinie CC' in einer p-Wanne 2 der n-Kanal-Transistor. Entlang der Schnittlinie BB' sind die Polysilizium-Gate-Elektroden 7 des p-Kanal- und des n-Kanal-Transistors mittels einer Polysiliziumbahn 7 miteinander verbunden. Das Polysilizium 7 der Gate-Elektroden ist im Bereich des p-Kanal-Transistors $p^+$-dotiert und im Bereich des n-Kanal-Transistors $n^+$-dotiert. Im Bereich der Wannenkante ändert sich die Dotierung von n nach p und es entsteht eine Polysiliziumdiode. Erfindungsgemäß befindet sich auf der Polysiliziumbahn 7 eine Metallsilizidschicht 13, welche die beim Übergang vom $p^+$-dotierten zum $n^+$-dotierten Polysilizium auftretende Polysiliziumdiode überbrückt. In einer ersten Ausführungsform der Erfindung befindet sich die Silizidschicht auf der gesamten Polysiliziumbahn 7. Die Silizidschicht schließt in dieser Ausführungsform nicht nur die Polysiliziumdiode kurz, sondern verringert auch den Schichtwiderstand der Gate-Elektrode und beeinflußt somit das Schaltverhalten der Transistoren. In einer weiteren bevorzugten Ausführungsform der Erfindung ist die Silizidschicht auf den Bereich um die Polysiliziumdiode beschränkt. Die Polysiliziumdiode wird kurzgeschlossen ohne die Eigenschaften der Transistoren zu verändern. Im folgenden werden beide Ausführungsformen der Erfindung anhand eines Verfahrens zu ihrer Herstellung erläutert.

Ausgegangen wird bei beiden Ausführungsformen von einem n-leitenden Substrat 1. Durch bekannte Verfahrensschritte werden im Substrat 1 p-leitende Wannengebiete 2 erzeugt. Anschließend werden die aktiven Gebiete 3, 4 mit Feldoxid 6 umgeben und mit Gateoxid 5 bedeckt. Nach der Abscheidung von Polysilizium werden die Polysilizium-Gate-Elektroden 7 strukturiert, so daß die Gate-Elektroden des n-Kanal- und des p-Kanal-Transistors auf Polysiliziumebene miteinander verbunden sind.

Beim Verfahren zur Herstellung der ersten Ausführungsform der erfindungsgemäßen Halbleiteranordnung erfolgt anschließend die $n^+$-Dotierung der aktiven Gebiete 4 und des Polysiliziums 7 im p-Wannengebiet 2 und die $p^+$-Dotierung der aktiven Gebiete 3 und des Polysiliziums 7 im n-leitenden Substratgebiet 1. Auf diese Weise entsteht ein n-Kanal-Transistor mit einer n-dotierten Polysilizium-Gate-Elektrode und ein p-Kanal-Transistor mit einer $p^+$-dotierten Polysilizium-Gate-Elektrode, wobei die Gate-Elektroden auf Polysiliziumebene miteinander verbunden sind. An der p-Wannenkante entsteht in der Polysiliziumbahn 7 beim Übergang von p- nach n-Dotierung eine Polysiliziumdiode. Im nächsten Verfahrensschritt wird ganzflächig Titan abgeschieden und in einem Hochtemperaturschritt getempert. Während des Hochtemperaturschrittes reagiert das Titan mit dem freiliegenden Silizium zu Titansilizid. Das Titan reagiert nicht mit dem darunterliegenden Siliziumoxid und kann anschließend von dort abgelöst werden. Wenn vor dem Abscheiden des Titans die Oxidschicht auf den aktiven Gebieten entfernt wurde, befindet sich Silizid auf der Polysiliziumbahn 7 und auf den aktiven Gebieten 3, 4, ansonsten ausschließlich auf der Polysiliziumbahn 7. Somit überbrückt die Silizidschicht die Polysiliziumdiode, die durch den Dotierungswechsel in der Polysiliziumbahn 7 an der p-Wannenkante entsteht und reduziert gleichzeitig den Schichtwiderstand der Polysilizium-Gate-Elektrode. Das führt zu einer Veränderung im Schaltverhalten eines aus diesem Transistorpaar aufgebauten CMOS-Gatters.

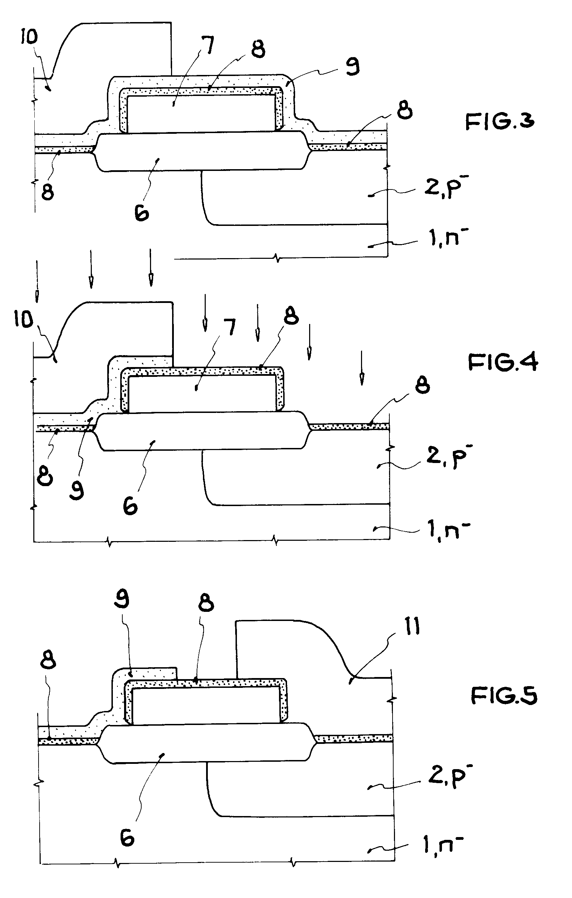

Soll das Metallsilizid auf den Bereich der Polysiliziumdiode beschränkt bleiben, so müssen die Verfahrensschritte, die auf die Polysiliziumstrukturierung folgen, abgeändert werden. Das Verfahren zur Herstellung der oben beschriebenen Halbleiteranordnung mit auf dem Bereich der Polysiliziumdiode beschränkter Silizidschicht ist im folgenden anhand der Figuren 3 bis 9 erläutert. Die Figuren 3 - 9 stellen den Schnitt BB' aus Figur 2 vergrößert dar. Nach der Polysiliziumstrukturierung wird die Polysiliziumbahn 7 mit einem Oxid 8 umgeben. Anschließend wird die gesamte Halbleiteroberfläche zunächst mit einer Nitridschicht 9 und mit einer ersten Fotolackschicht 10 bedeckt. Die erste Fotolackschicht 10 wird in einem Belichtungs- und Ätzschritt so strukturiert, daß die über der p-Wanne liegende Halbleiteroberfläche und eine über die p-Wannenkante hinausgehende, über dem n-Substratgebiet liegende Randzone von der ersten Fotolackschicht 10 befreit werden (Figur 3).

Im nächsten Verfahrensschritt wird die zuvor freigelegte Nitridschicht 9 entfernt und anschließend die Halbleiteroberfläche durch Phosphorimplantation dotiert. Die Störstellenatome dringen nur in die von der ersten Fotolackschicht 10 und Nitridschicht 9 freigelegten Flächen wirksam ein und können in einem späteren Verfahrensschritt aktiviert werden (Figur 4).

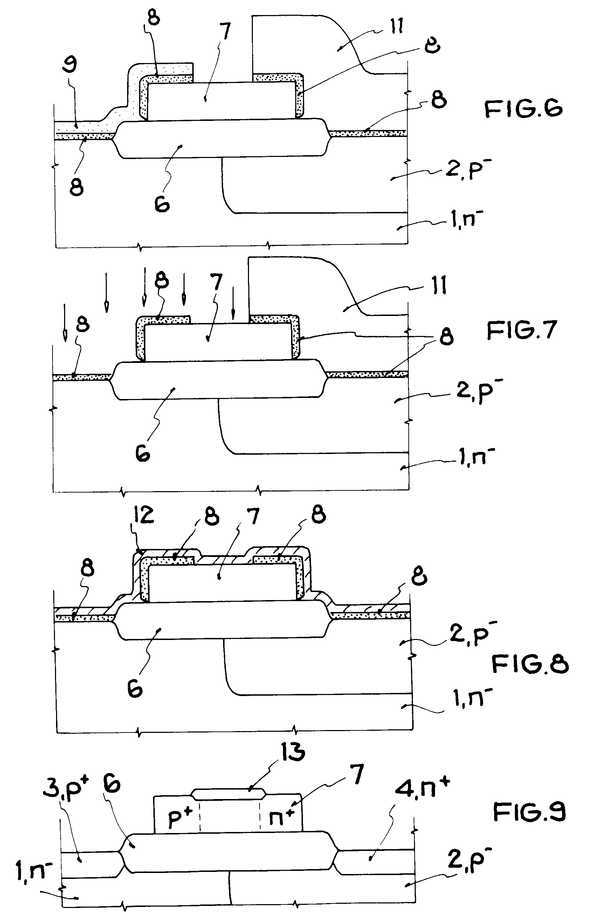

Nach der Störstellenimplantation wird die verbliebene erste Fotolackschicht 10 entfernt und eine zweite Fotolackschicht 11 aufgetragen. Die zweite Fotolackschicht 11 wird in einem Belichtungs- und Ätzschritt so strukturiert, daß die über dem n-Substratgebiet liegende Oberfläche und eine über die p-Wannenkante hinausgehende, über dem p-Wannengebiet liegende Randzone von der zweiten Fotolackschicht 11 befreit werden (Figur 5).

An der Oberfläche der Halbleiteranordnung befindet sich über dem n-Substratgebiet die Nitridschicht 9, über dem p-Wannengebiet die zweite Fotolackschicht 11 und über der p-Wannenkante im Bereich der Randzone die Oxidschicht 8. Dieser an der Oberfläche liegende Bereich der Oxidschicht 8 wird im nächsten Verfahrensschritt abgelöst, so daß das darunterliegende Polysilizium 7 im Bereich der Wannenkante freigelegt wird (Figur 6). Danach wird die verbleibende Nitridschicht 9 entfernt und bei der folgenden Borimplantation werden Störstellen in die nicht von der zweiten Fotolackschicht 11 bedeckten Halbleiterbereiche eingebracht (Figur 7).

Dann wird die zweite Fotolackschicht 11 entfernt und die gesamte Halbleiteroberfläche mit Titan 12 beschichtet (Figur 8). Anschließend wird die Halbleiteranordnung in einem Hochtemperaturschritt getempert. Dabei werden die implantierten Störstellen in den aktiven Gebieten 3, 4 und der Polysiliziumbahn 7 aktiviert und gleichzeitig reagiert das Titan 12 an den Stellen, an denen es mit Silizium in Kontakt kommt zu Titansilizid. Das auf dem Oxid und dem Feldoxid liegende Titan reagiert nicht und kann anschließend entfernt werden.

Figur 9 zeigt einen Ausschnitt aus der erfindungsgemäßen Halbleiteranordnung. Die Polysiliziumbahn 7 ist im Bereich der Wannenkante, wo die Dotierung von n nach p umschlägt mit einer Polysilizidschicht 13 effektiv überbrückt. Die Polysiliziumbahn 7 ist im Bereich der p-Wanne stark n-dotiert und im Bereich des n-Substrates stark p-dotiert. Direkt über der Wannenkante entsteht durch das versetzte Maskieren ein Bereich dessen effektive Dotierung von den beiden Implantationsschritten abhängt. Die darüberliegende Polysilizidschicht kontaktiert jedoch die beiden an das hochohmige zentrale Gebiet angrenzenden niederohmigen Gebiete, da sich das Silizid aufgrund der hohen Beweglichkeit des Titans während des Hochtemperaturschritts in die beiden niederohmigen Gebiete ausgedehnt hat.

An die oben beschriebenen Verfahrensschritte schließen sich die üblichen Verfahrensschritte zur Metallisierung, Passivierung etc. an.

Die Erfindung ist ebenso anwendbar bei CMOS-Prozessen mit p-leitendem Substrat und n-leitenden Wannengebieten.

Durch die erfindungsgemäßen Halbleiteranordnungen werden die Polysiliziumdioden beim Übergang der Polysiliziumbahn 7 vom Substratgebiet ins Wannengebiet effektiv überbrückt.

Durch die beiden oben beschriebenen selbstjustierenden Verfahren können die Polysiliziumdioden ohne zusätzlichen Maskenaufwand kurzgeschlossen werden.

Das Verfahren ist auch bei Halbleiteranordnungen mit anderen Wannenkomplexen, bei jeder Art von Oxid-Isolation und Source/Drain-Implantation anwendbar. Ebenso finden neben Titan alle anderen salizidfähigen Metalle Anwendung.

**Patentansprüche**

1. Halbleiteranordnung mit einem n-Kanal- und einem p-Kanal-MOS-Transistor, wobei die Polysilizium-Gate-Elektroden der beiden Transistoren entsprechend ihrem Kanaltyp dotiert und miteinander verbunden sind, so daß an der Verbindungsstelle eine Polysiliziumdiode entsteht, dadurch gekennzeichnet, daß die Polysiliziumdiode durch ein Metallsilizid überbrückt wird.

2. Halbleiteranordnung nach Anspruch 1, dadurch gekennzeichnet, daß die Polysiliziumbahn (7), aus der die beiden Gate-Elektroden und deren Verbindung besteht, ganzflächig mit einer Metallsilizidschicht (13) versehen wird.

3. Halbleiteranordnung nach Anspruch 1, dadurch gekennzeichnet, daß die Polysiliziumbahn (7), aus der die beiden Gate-Elektroden und deren Verbindung besteht, nur im Bereich der Polysiliziumdiode mit einer Metallsilizidschicht (13) versehen wird.

4. Verfahren zur Herstellung einer Halbleiter nach Anspruch 2, gekennzeichnet durch den Ablauf folgender Verfahrensschritte:
   - Herstellung von Wannengebieten (2) des zweiten Leitfähigkeitstyps in einem Halbleitersubstrat (1) des ersten Leitfähigkeitstyps;
   - Strukturierung aktiver Gebiete (3, 4) des p- und n-Kanal-Transistors durch Feldoxid;
   - Bedecken der aktiven Gebiete (3, 4) mit Gateoxid (5);
   - Abscheiden von Polysilizium auf der gesamten Oberfläche;
   - Strukturierung des Polysiliziums, wobei eine Polysiliziumbahn (7) entsteht, die über die Wannenkante läuft und die beide Gate-Elektroden bildet;
   - Implantation der aktiven Gebiete (3) und der Polysiliziumbahn (7) im Substratgebiet (1);
   - Implantation der aktiven Gebiete (4) und der Polysiliziumbahn (7) im Wannengebiet (2);
   - Abscheiden von Titan auf der gesamten Oberfläche;
   - Hochtemperaturschritt, bei dem das Titan mit Silizium zu Titansilizid reagiert und gleichzeitig die Dotierungsstoffe aktiviert werden;
   - Abtragen des metallischen Titans;
   - Übliche Verfahrensschritte zur Passivierung, Metallisierung, etc.

5. Verfahren nach Anspruch 4, dadurch gekennzeichnet, daß vor dem Verfahrensschritt der Titanabscheidung das Gateoxid (5) von den aktiven Gebieten entfernt wird und somit auch auf den aktiven Gebieten (3, 4) eine Silizidschicht entsteht.

6. Verfahren zur Herstellung einer Halbleiteranordnung nach Anspruch 3, gekennzeichnet durch den Ablauf folgender Verfahrensschritte:
   - Herstellung von Wannengebieten (2) des zweiten Leitfähigkeitstyps in einem Halbleitersubstrat (1) des ersten Leitfähigkeitstyps;
   - Strukturierung aktiver Gebiete (3, 4) des p- und n-Kanal-Transistors durch Feldoxid;
   - Bedecken der aktiven Gebiete (3, 4) mit Gateoxid (5);
   - Abscheiden von Polysilizium auf der gesamten Oberfläche;
   - Strukturierung des Polysiliziums, wobei eine Polysiliziumbahn (7) entsteht, die über die Wannenkante läuft und die beide Gate-Elektroden bildet;
   - Bildung einer Oxidschicht (8) auf der Polysiliziumbahn (7);
   - Abscheidung einer Nitridschicht (9) und einer ersten Photolackschicht (10) auf der gesamten Oberfläche;
   - Strukturieren der ersten Photolackschicht (10), so daß die Oberfläche über dem Substratgebiet (1) mit Photolack bedeckt ist, wobei der Photolack von der Wannenkante zurückversetzt ist;
   - Entfernen der freigelegten Nitridschicht (9);
   - Implantation von Dotierungsstoffen des ersten Leitungstyps;
   - Entfernen der ersten Photolackschicht (10) und aufbringen einer zweiten Photolackschicht (11) auf der gesamten Oberfläche;
   - Strukturieren der zweiten Photolackschicht (11), so daß die Oberfläche über dem Wannengebiet (2) mit Photolack bedeckt ist, wobei der Photolack von der Wannenkante zurückversetzt ist;
   - Entfernen der auf der Polysiliziumbahn (7) liegenden Oxidschicht soweit diese nicht von der Nitridschicht (9) oder der zweiten Photolackschicht bedeckt ist;
   - Entfernen der restlichen Nitridschicht (9);
   - Implantation von Dotierungsstoffen des zweiten Leitungstyps;
   - Entfernen der zweiten Photolackschicht (11);
   - Abscheiden von Titan auf die gesamte

**EP 0 520 209 A1**

Oberfläche;

- Hochtemperaturschritt, bei dem das Titan mit Silizium zu Titansilizid reagiert und gleichzeitig die Dotierungsstoffe aktiviert werden;
- Abtragen des metallischen Titans;
- Übliche Verfahrensschritte zur Passivierung, Metallisierung, etc.

FIG.1

FIG.2

FIG.3

FIG.4

FIG.5

FIG.6

FIG.7

FIG.8

FIG.9

Europäisches
Patentamt

**EUROPÄISCHER RECHERCHENBERICHT**

Nummer der Anmeldung

EP    92 10 9256

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | PATENT ABSTRACTS OF JAPAN vol. 8, no. 155 (E-256)(1592) 19. Juli 1984 & JP-A-59 057 469 ( FUJITSU LTD. ) 3. April 1984 * Zusammenfassung * --- | 1-2 | H01L27/092 H01L21/82 |
| X A | EP-A-0 098 737 (FUJITSU LTD.) 18. Januar 1984 * Seite 7, Zeile 6 - Seite 11, Zeile 4; Abbildungen 5A-5B * --- | 1,3  6 | |
| X | INTERNATIONAL ELECTRON DEVICES MEETING 1983 5. Dezember 1983, WASHINGTON D.C.,USA Seiten 518 - 521 Y. MURAO ET AL. 'A high performance CMOS technology with Ti-silicided P/N-type poly-Si gates.' * the whole document * --- | 5 | |
| X A | FR-A-2 558 010 (SGS-ATES COMPONENTI ELETTRONICI SPA) 12. Juli 1985 * Seite 8, Zeile 26 - Seite 11, Zeile 31; Abbildungen 8-13 * --- | 1-2  6 | RECHERCHIERTE SACHGEBIETE (Int. Cl.5) H01L |
| A | EP-A-0 139 371 (TEKTRONIX, INC.) 2. Mai 1985 * Seite 16, Zeile 17 - Seite 20, Zeile 6; Ansprüche 1-3,7; Abbildungen 2A-2H,4 * ----- | 5 | |

Der vorliegende Recherchenbericht wurde für alle Patentansprüche erstellt

| Recherchenort | Abschlußdatum der Recherche | Prüfer |
|---|---|---|
| DEN HAAG | 06 OKTOBER 1992 | FRANSEN L.J.L. |